# EUROPÄISCHE PATENTSCHRIFT

(11) **EP 2 920 665 B1**
(45) Veröffentlichungstag und Bekanntmachung des Hinweises auf die Patenterteilung: **13.03.2019**
(21) Anmeldenummer: 13794877.4
(22) Anmeldetag: 19.11.2013
(51) Int. Cl.: G05G 1/02, H03K 17/96, G01D 5/241, H01G 5/00

(54) **BEDIENVORRICHTUNG FÜR EINE FAHRZEUGKOMPONENTE**
OPERATING DEVICE FOR A VEHICLE COMPONENT
DISPOSITIF DE COMMANDE POUR UN APPAREIL DE VÉHICULE

(30) Priorität: 19.11.2012 DE 102012221107
(43) Veröffentlichungstag der Anmeldung: 23.09.2015
(73) Patentinhaber: Behr-Hella Thermocontrol GmbH, 70469 Stuttgart (DE)
(72) Erfinder: MARQUAS, Karsten, 59757 Arnsberg (DE)
(74) Vertreter: dompatent von Kreisler Selting Werner - Partnerschaft von Patent- und Rechtsanwälten mbB
(86) Internationale Anmeldenummer: PCT/EP2013/074155
(87) Internationale Veröffentlichungsnummer: WO 2014/076299

(56) Entgegenhaltungen:
- EP-A1- 1 988 441
- WO-A1-2013/153048

## Beschreibung

Die Erfindung betrifft eine Bedienvorrichtung für eine Fahrzeugkomponente, bei der es sich insbesondere um ein Radio, ein CD- und/ oder DVD-Abspielgerät, ein Navigationsgerät, ein Infotainment-Gerät, ein Heizungs- oder Klimasteuergerät oder allgemein um ein Mensch-Maschine-Interface handelt.

Bedienvorrichtungen für insbesondere Fahrzeugkomponenten weisen im Regelfall eine Frontblende oder Vorderseite auf, an der eine Vielzahl von gegebenenfalls auch unterschiedlich ausgestalteten Bedienelementen, in Form von z.B. Drehknöpfen, Drucktastern, Wippschaltern oder dergleichen angeordnet sind. Zusätzlich existieren auch Bedienelemente in Form von, von der Vorderseite abstehenden Tastenkörpern, die ein Betätigungsende aufweisen, das eine Oberseite und eine Unterseite aufweist. Derartige Bedienelemente werden mitunter auch Balkontasten genannt, da ihre Betätigungsenden über die Vorderseite der Bedienvorrichtung vorstehen.

Ein derartiger Tastenkörper kann, als Betätigungsleiste ausgebildet, mehrere Symbolfelder aufweisen (beispielsweise mehrere mit fortlaufenden Ziffern versehene, nebeneinanderliegende Bereiche), wobei sich der gesamte Tastenkörper unabhängig davon, in welchem Bereich er betätigt wird, bewegt. Durch eine kapazitive Näherungssensorik kann erkannt werden, welches Symbolfeld mit dem Finger einer Hand bei Betätigung des Tastenkörpers berührt wird.

Es hat sich ferner herausgestellt, dass es für den Bedienkomfort vorteilhaft sein kann, wenn sich der Tastenkörper bei Betätigung im Wesentlichen nur unmerklich bewegen lässt. Über eine akustische oder haptische Rückmeldung kann dann für den Bediener eine Bestätigung der Betätigung des Tastenkörpers erfolgen.

Aus EP 1 988 441 A1 ist eine Bedienvorrichtung für eine Fahrzeugkomponente bekannt, wobei die Bedienvorrichtung versehen ist mit einem Gehäuse mit einer Vorderseite und einem eine Längserstreckung aufweisenden Tastenkörper, der ein über die Vorderseite des Gehäuses vorstehendes Betätigungsende und ein innerhalb des Gehäuses angeordnetes Lagerende aufweist. Das Betätigungsende weist eine Oberseite sowie eine Unterseite auf, die sich in einem Winkel von ungleich Null Winkelgrad über die Vorderseite überstehend erstrecken und die zur Eingabe eines Bedienbefehls durch manuelle auf die Ober- oder Unterseite erfolgende Kraftausübung betätigbar ist.

Aufgabe der Erfindung ist es, eine Bedienvorrichtung mit einem über die Vorderseite des Gehäuses der Bedienvorrichtung vorstehenden Tastenkörper zu schaffen, der eine genaue, reproduzierbare und insbesondere gleichbleibende Bewegung bei seiner Betätigung ausführt.

Zur Lösung dieser Aufgabe wird mit der Erfindung eine Bedienvorrichtung für eine Fahrzeugkomponente, insbesondere für ein Radio, ein CD- und/ oder DVD-Abspielgerät, ein Navigationsgerät, ein Infotainment-Gerät, ein Heizungs- oder Klimasteuergerät oder für ein Mensch-Maschine-Interface vorgeschlagen, wobei die Bedienvorrichtung versehen ist mit den Merkmalen des Anspruchs 1. Einzelne Ausgestaltungen der Erfindung sind Gegenstand der Unteransprüche.

Der erfindungsgemäße Tastenkörper, der ähnlich wie die Spacebar-Taste einer Computertastatur eine langgestreckte Betätigungsleiste hat, steht über die Vorderseite des Gehäuses über. Innerhalb des Gehäuses befindet sich ein Trägerkörper mit einem Lager zur (geringfügig bewegbaren) Lagerung des Tastenkörpers in zwei zueinander im Wesentlichen orthogonalen Raumrichtungen bzw. -achsen. Das Betätigungsende des Tastenkörpers ragt über die Vorderseite des Gehäuses. Das Betätigungsende (d.h. die Betätigungsleiste) weist eine Ober- und eine Unterseite auf, die in einem Winkel von ungleich Null Winkelgrad über die Vorderseite überstehen. Durch manuelle Kraftausübung auf die Ober- bzw. Unterseite erfolgt eine geringfügige Bewegung des Tastenkörpers nach unten bzw. nach oben.

Die Besonderheit der erfindungsgemäßen Bedienvorrichtung besteht in der Ausgestaltung des Lagers, das mindestens drei Aufhängungselemente aufweist. Diese drei Aufhängungselemente sind auf zwei Aufhängungsebenen aufgeteilt, die im Wesentlichen winklig zur Vorderseite verlaufen und zueinander im Wesentlichen parallel sowie auch im Wesentlichen parallel zur Längserstreckung des Tastenkörpers sind.

Durch die Aufhängungselemente, bei denen es sich um biegesteife, rückstellfähige Elemente in Form beispielsweise von Stäben oder dergleichen handelt, kommt es bei Betätigung des Tastenkörpers zu einer geringfügigen Parallelverschiebung desselben relativ zur Vorderseite des Gehäuses. Dabei ist entscheidend, dass die erfindungsgemäße Art der Anordnung und Ausgestaltung der Aufhängungselemente für eine spielfreie Lagerung des Tastenkörpers an dem Trägerkörper sorgen. Außerdem ist die Lagerung des Tastenkörpers geräuscharm.

Mit dem erfindungsgemäßen Konzept ist es mit Vorteil möglich, die haptische Rückmeldung einer Bedienung der Betätigungsleiste bzw. des Betätigungsendes des Tastenkörpers durch einen Vibrationen erzeugenden Aktuator zu realisieren, der den Tastenkörper in orthogonal zu seiner Betätigung gerichtete Schwingungen versetzt. Denn die erfindungsgemäße Lagerung erlaubt durch sowohl am Trägerkörper als auch am Tastenkörper eingespannte Aufhängungselemente eine Parallelverschiebung des Tastenkörpers relativ zur Vorderseite der Bedienvorrichtung bzw. zum Trägerkörper.

In weiterer vorteilhafter Ausgestaltung der Erfindung ist vorgesehen, dass das Lager ein vom Trägerkörper abstehendes Vorsprungselement aufweist, das im Wesentlichen in der gleichen Raumrichtung wie die Aufhängungselemente von dem Trägerkörper absteht und zwischen den beiden Aufhängungselementen angeordnet ist, und dass der Tastenkörper an dem Vorsprungselement des Lagers gegebenenfalls anliegt.

Zweckmäßig ist es, wenn vier Aufhängungselemente vorhanden sind, die zur Lagerung des Tastenkörpers an dem Trägerkörper dienen. Dabei sind dann jeweils zwei Aufhängungselemente in einer gemeinsamen Aufhängungsebene angeordnet. Zweckmäßig ist es, wenn an den beiden entgegengesetzten Endbereichen der Betätigungsleiste bzw. des Tastenkörpers jeweils zwei Aufhängungselemente befestigt sind, die in den beiden unterschiedlichen Aufhängungsebenen angeordnet sind.

Es ist aber ebenso denkbar, dass in der einen Aufhängungsebene zwei Aufhängungselemente und in der anderen Aufhängungsebene lediglich ein Aufhängungselement angeordnet ist. In jeder Aufhängungsebene können auch mehr als zwei Aufhängungselemente angeordnet sein.

Durch die feste Einspannung der Aufhängungselemente sowohl am Trägerkörper als auch an der Betätigungsleiste kommt es zu dem oben angesprochenen Parallelversatz der Betätigungsleiste bei deren Bedienung.

Als Aufhängungselemente eignen sich insbesondere Federstahlstäbe, d.h. allgemeiner ausgedrückt, druck- als auch zugkraftwiderstandsfähige und biegesteife, insbesondere rückstellfähige Aufhängungselemente. Bei diesen Aufhängungselementen handelt es sich beispielsweise um strangförmige Elemente (runde oder eckige Stäbe). Hierbei verbiegen sich die Aufhängungselemente über ihre gesamte Erstreckung zwischen dem Trägerkörper und dem Tastenkörper in den beiden im Wesentlichen orthogonal zueinander verlaufenden Raumachsen. Es sind aber auch Konzepte für die Aufhängungselemente denkbar, bei denen zwei getrennte Abschnitte eines Aufhängungselements für die Verbiegbarkeit in jeweils einer anderen der beiden Raumachsen verantwortlich sind. In diesem Fall kann jedes Aufhängungselement ein rückstellfähiges flaches Streifenmaterial, insbesondere ein Federstahlband, aufweisen, das um seine Längsachse um 90 ° gedreht relativ zueinander ausgerichtet ist. Alternativ kann jeder der Abschnitte als U-förmig gebogenes, rückstellfähiges, flaches Streifenmaterial, insbesondere Federstahlband, ausgebildet ist und die beiden U-förmigen Streifenmaterialabschnitte bezüglich ihrer beiden Paare von Schenkeln um 90 ° zueinander verdreht sowie ausgehend von ihren Basisabschnitten in entgegengesetzte Richtungen weisend ausgerichtet sind.

In weiterer vorteilhafter Ausgestaltung der Erfindung kann vorgesehen sein, dass die Erfassung einer Parallelverschiebung des Tastenkörpers bei manueller Kraftausübung auf die Ober- oder Unterseite der Betätigungsleiste ein Bewegungssensor vorgesehen ist. Dieser Bewegungssensor erkennt eine Bedienung der Betätigungsleiste und ist beispielsweise als Druck- oder Kraftsensor ausgebildet. Die Bedienvorrichtung weist darüber hinaus zweckmäßigerweise eine Auswerteeinheit zur Umsetzung eines Bedienbefehls bei Betätigung des Tastenkörpers auf. Diese Auswerteeinheit kann dann beispielsweise auch den bereits oben angesprochenen Aktuator ansteuern, wenn über den Bewegungssensor eine Bedienung der Betätigungsleiste des Tastenkörpers erkannt wird.

In weiterer vorteilhafter Ausgestaltung der Erfindung kann die Bedieneinheit mit einem kapazitiven Sensor zur Erfassung einer Relativbewegung von Tastenkörper und Trägerkörper versehen sein, wobei der kapazitive Sensor selbst versehen ist mit,
- einer ersten Elektrode, die eine erste elektrisch leitende Elektrodenfläche aufweist und an einem ersten Elektroden-Trägerkörper angeordnet ist,
- einer der ersten Elektrode gegenüberliegenden zweiten Elektrode, die eine zweite elektrisch leitende Elektrodenfläche aufweist und an einem zweiten Elektroden-Trägerkörper angeordnet ist,
- wobei der zweite Elektroden-Trägerkörper als rückstellfähiges Folienelement ausgebildet ist, das sich an zwei voneinander beabstandeten, gegenüberliegenden Abstützabschnitten beidseitig der beiden Elektroden an dem ersten Elektroden-Trägerkörper abstützt, und
- einem Andrückkörper auf der der zweiten Elektrode abgewandten Seite des zweiten Elektroden-Trägerkörpers,
- wobei der Andrückkörper mindestens zwei Andrückvorsprünge aufweist, die im Bereich zwischen den Abstützabschnitten des zweiten Elektroden-Trägerkörpers an dessen der zweiten Elektrode abgewandten Seite anliegen und die bei einer Relativbewegung des ersten Elektroden-Trägerkörpers und des zweiten Andrückkörpers unter Verbiegung des zweiten Elektroden-Trägerkörpers gegen diesen drücken,
- wobei die mindestens zwei Andrückvorsprünge bezüglich der gleichen Raumrichtung, in der die Abstützabschnitte des zweiten Elektroden-Trägerkörpers beabstandet sind, einen Abstand von einander aufweisen, und
- wobei die zweite Elektrode an dem zweiten Elektroden-Trägerkörper lediglich in einem Befestigungsabschnitt befestigt ist, der sich im Wesentlichen in der Mitte zwischen den Andrückbereichen des zweiten Elektroden-Trägerkörpers befindet, in welchen die Andrückvorsprünge an dem zweiten Elektroden-Trägerkörper anliegen, so dass der Bewegungshub zwischen dem Andrückkörper und dem zweiten Elektroden-Trägerkörper in einem gegenüber diesem Bewegungshub größeren Bewegungshub zwischen den beiden Elektroden umsetzbar ist.

Der kapazitive Sensor ist derart konstruiert, dass eine mechanische Übersetzung der Bewegung der beiden Körper in eine größere Annäherung bzw. Abstandsänderung der beiden Elektroden umgesetzt wird, so dass bei geringem elektrischen Verstärkungsverhältnissen dennoch kleine Hübe sicher detektiert werden können. Dies hat seine Ursache in der Ausbildung, insbesondere des zweiten Elektroden-Trägerkörpers als rückstellfähiges Folienelement, an dem die zweite Elektrode lediglich in einem einzigen (Mitten-) Bereich fixiert ist. Der zweite Elektroden-Trägerkörper stützt sich dabei an dem ersten Elektroden-Trägerkörper, der seinerseits die erste Elektrode trägt, ab und zwar an zwei gegenüberliegenden Abstützabschnitten. Diese beiden Abstützabschnitte liegen außerhalb beider Elektroden. Zwischen diesen Abstützabschnitten und beidseitig des Befestigungsbereichs der zweiten Elektrode am zweiten Elektroden-Trägerkörper drückt gegen diesen zweiten Elektroden-Trägerkörper ein Andrückkörper, der zu diesem Zweck zwei Andrückvorsprünge aufweist. Durch die Durchbiegung des rückstellfähigen zweiten Elektroden-Trägerkörpers, wenn die Andrückvorsprünge gegen den zweiten Elektroden-Trägerkörper drücken, wird die zweite Elektrode in Richtung auf die erste Elektrode vorbewegt, und zwar in einem größeren Maße, als sich der erste Elektroden-Trägerkörper relativ zum Andrückkörper bewegt. Damit ist eine mechanische Übersetzung, wie oben beschrieben, realisiert.

In vorteilhafter Weiterbildung des kapazitiven Sensors kann vorgesehen sein, dass die Anordnung aus den Abstützabschnitten des zweiten Elektroden-Trägerkörpers an dem ersten Elektroden-Trägerkörper und den Andrückvorsprüngen des Andrückkörpers symmetrisch zum Befestigungsbereich des zweiten Elektroden-Trägerkörpers für die zweite Elektrode.

Ferner kann es von Vorteil sein, wenn der erste Elektroden-Trägerkörper eine an zumindest zwei gegenüberliegenden Seiten durch Begrenzungsrandabschnitte begrenzte Vertiefung aufweist, innerhalb derer die erste Elektrode angeordnet ist, wobei sich der zweite Elektroden-Trägerkörper mit seinen Abstützabschnitten auf den Begrenzungsrandabschnitten abstützt.

In weiterer vorteilhafter Ausgestaltung des kapazitiven Sensors ist vorgesehen, dass der erste Elektroden-Trägerkörper auf seiner der ersten Elektrode abgewandten Seite eine weitere erste Elektrode aufweist und dass ein weiterer zweiter Elektroden-Trägerkörper mit einer weiteren zweiten Elektrode sowie mit weiteren Abstützabschnitten und ein weiterer Andrückkörper mit weiteren Andrückvorsprüngen vorgesehen sind, deren Anordnung relativ zueinander so, wie in einem der vorhergehenden Ansprüchen beschrieben, getroffen ist. Schließlich sei noch darauf hingewiesen, dass sich als Folienelement insbesondere Federstahl eignet.

Die Erfindung wird nachfolgend anhand eines Ausführungsbeispiels und unter Bezugnahme auf die Zeichnung näher erläutert. Im Einzelnen zeigen dabei:
- Fig. 1: eine perspektivische Darstellung eines Teils einer beispielhaften Bedienvorrichtung,
- Fig. 2: eine perspektivische, geschnittene Ansicht des Lagers zur spielfreien und geräuscharmen Lagerung des Tastenkörpers an dem Trägerkörper (entsprechend der Schnittlinie II-II der Fig. 3),
- Fig. 3: eine Schnittansicht durch das Lager mit in diesem integrierten Druckbzw. Kraftsensor als Bewegungssensor zur Erkennung einer Tastenkörper- bzw. Betätigungsleistenbedienung und
- Fign. 4 und: 5 die Bewegung des Tastenkörpers relativ zum Trägerkörper bei Ausübung von Druck auf die Unter- bzw. Oberseite der Betätigungsleiste des Tastenkörpers,
- Fign. 6 und: 7 ein zweites Ausführungsbeispiel für die Ausbildung der Aufhängungselemente und
- Fig. 8: ein weiteres Ausführungsbeispiel eines Aufhängungselements.

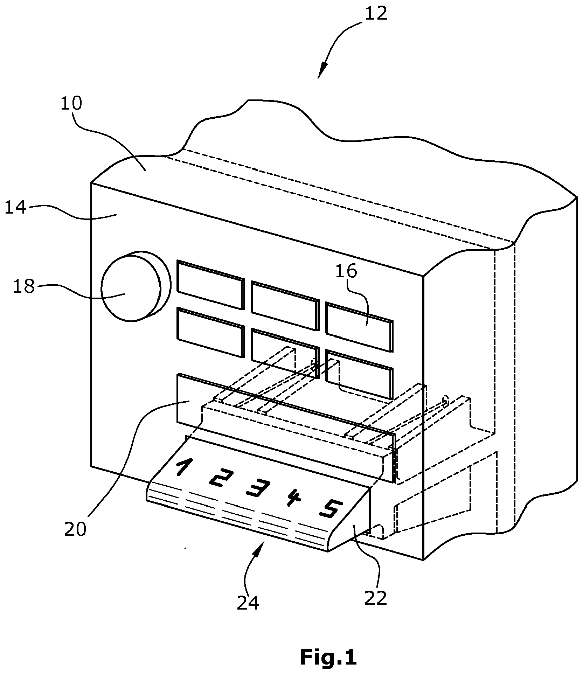

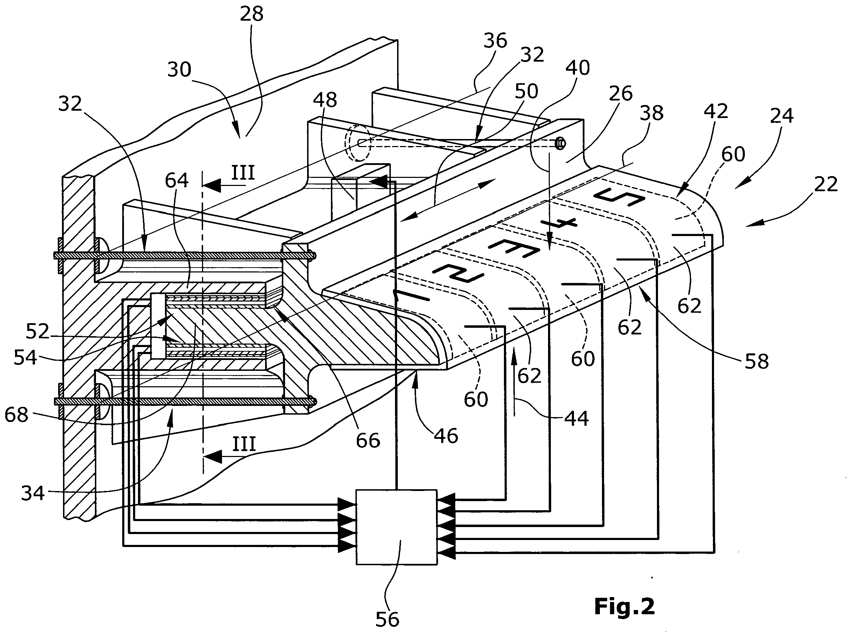

Fig. 1 zeigt perspektivisch ein Gehäuse 10 einer Bedienvorrichtung 12. Das Gehäuse 10 weist eine Vorderseite 14 mit Drucktasten 16, einem Drehknopf 18, einer Anzeigeeinheit 20 sowie mit einer Betätigungsleiste 22 auf. Die Betätigungsleiste 22 bildet das Betätigungsende 24 eines Tastenkörpers 26 (siehe Fig. 2), der an einem Trägerkörper 28 gelagert ist, welcher seinerseits innerhalb des Gehäuses 10 angeordnet ist.

Zur Lagerung des Tastenkörpers 26 dient ein Lager 30, das in diesem Ausführungsbeispiel vier Aufhängungselemente 32,34 aufweist (in Fig. 2 ist eines der beiden Aufhängungselemente 34 nicht zu erkennen), die auf zwei zueinander parallelen Aufhängungsebenen 36,38 verteilt, angeordnet sind. Die Aufhängungselemente 32,34 sind paarweise an den in Längserstreckung der Betätigungsleiste 22 angeordneten Enden des Tastenkörpers 26 angeordnet. Sie sind sowohl am Trägerkörper 28 als auch am Tastenkörper 26 eingespannt gehalten, so dass sich bei einer Kraftausübung in Richtung des Pfeils 40 auf die Oberseite 42 der Betätigungsleiste 22 als auch bei Kraftausübung in Richtung des Pfeils 44 auf die Unterseite 46 der Betätigungsleiste 22 eine Parallelverschiebung der Betätigungsleiste 22 relativ zum Trägerkörper 28 ergibt. Diese Parallelverschiebung ist hoch präzise, spielfrei, geräuscharm und minimal, wenn die Betätigungsleiste 22 betätigt wird.

Wie anhand von Fig. 2 angedeutet, wirkt zwischen dem Trägerkörper 28 und dem Tastenkörper 26 oder auf den Tastenkörper 26 ein Vibrationsaktuator 48, der den Tastenkörper 26 in Richtung des Doppelpfeils 50 in Vibrationen versetzt, wenn die Betätigungsleiste 22 des Tastenkörpers 26 betätigt wird. Alternativ zu einem oszillierenden Vibrationsaktuator 48 kann auch ein anderer Mechanismus verwendet werden, der z.B. elektro- bzw. magnetomechanisch arbeitet und beispielsweise ein U-förmiges magnetisches Joch mit einer Spule zur impulsartigen Anregung/Erzeugung eines Magnetfeldes zum Anziehen/Abstoßen eines Magnetankers aufweist und den Tastenkörper 26 in die eine Querrichtung bewegt, wobei sich der Tastenkörper 26 automatisch wieder zurückbewegt (beim Stromlos-Schalten der Spule), und zwar in Folge der mechanischen Rückstellspannung in den Aufhängungselementen 34 bei deren Verformung durch die Querbewegung. Das Joch und der Magnetanker sind am Trägerkörper 28 bzw. Tastenkörper 26 angebracht, so dass sich derjenige Körper, der mit dem Magnetanker verbunden ist, gegenüber dem anderen Körper (oder umgekehrt) vor- und zurückbewegt.

Die Bedienung der Betätigungsleiste 22 wird durch weiter unten noch zu beschreibende, in diesem Ausführungsbeispiel kapazitiv arbeitende Druck- bzw. Kraft- bzw. Wegsensoren 52,54 erkannt, die elektrisch mit einer Auswerteeinheit 56 verbunden sind, welche u. a. auch den Vibrationsaktuator 48 ansteuert. Zusätzlich umfasst der Tastenkörper 26 eine Näherungssensorik 58 in Form von kapazitiv wirkenden Elektroden 60, die unterschiedlichen Symbolfeldern 62 der Betätigungsleiste 22 zugeordnet sind. Über die beiden Sensoren 52,54 (wobei auch nur ein Sensor ausreichen würde) kann also erkannt werden, ob die Betätigungsleiste 22 betätigt worden ist oder nicht. Darüber hinaus wird durch die kapazitive Näherungssensorik 58 erkannt, an welchem der Symbolfelder 62 der Finger einer Hand bei Bedienung der Betätigungsleiste 22 anliegt. Die Quittierung der Erkennung der Bedienung der Betätigungsleiste 22 erfolgt sodann durch Ansteuerung des Vibrationsaktuators 48 o.dgl. Bewegungsmechanismus (siehe oben), was zu einer taktilen Rückmeldung führt und damit vom Benutzer erkannt wird.

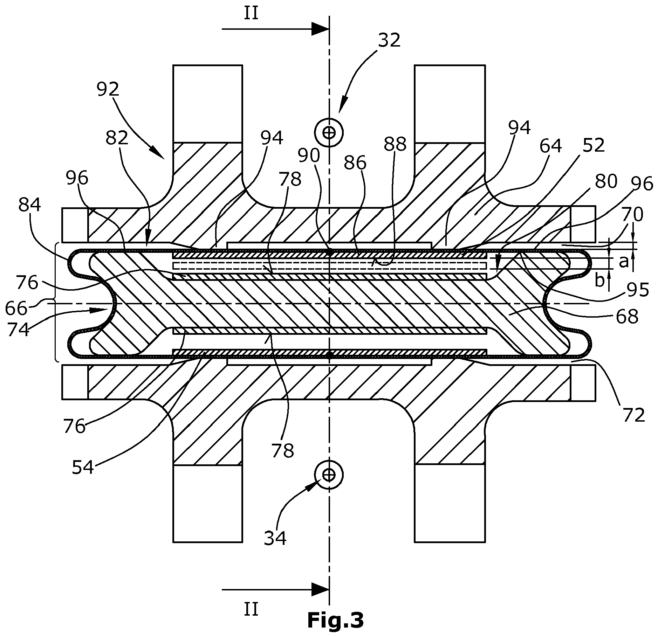

Wie beispielsweise anhand von Fig. 2 zu erkennen ist, erstreckt sich von dem Trägerkörper 28 ein Vorsprungselement 64, das einen zum Tastenkörper 26 hin offenen Aufnahmeraum 66 aufweist. In diesen Aufnahmeraum 66 ragt als Lagerende des Tastenkörpers 28 ein Fortsatz 68 desselben. Zwischen dem Fortsatz 68 und dem Vorsprungselement 64 befinden sich zwei Zwischenräume 70,72 (siehe Fig. 3), zwischen denen jeweils einer der Sensoren 52,54 angeordnet ist. Bei Bedienung der Betätigungsleiste 22 verschiebt sich der Fortsatz 68 innerhalb des Aufnahmeraums 66 unter Beibehaltung seiner Ausrichtung (wegen der oben angesprochenen Parallelverschiebung des Tastenkörpers 26) nach oben bzw. nach unten, was über die beiden Sensoren 52,54 (bzw. einen der beiden Sensoren) erkannt wird.

Der Aufbau der Sensorik ist beispielhaft anhand von Fig. 3 zu erkennen. Der Fortsatz 68 bildet einen ersten Elektroden-Trägerkörper 74, der eine erste Elektrode 76 mit einer Elektrodenfläche 78 trägt. Diese Elektrode 76 ist innerhalb einer Vertiefung 80 des ersten Elektroden-Trägerkörpers 74 angeordnet. Die Vertiefung 80 wird von einem zweiten Elektroden-Trägerkörper 82 überspannt, der in diesem Ausführungsbeispiel als Federstahl-Folienelement 84 ausgebildet ist. An dem zweiten Elektroden-Trägerkörper 82 befindet sich eine zweite Elektrode 86 mit einer der Elektrodenfläche 78 der ersten Elektrode 76 zugewandten zweiten Elektrodenfläche 88. Die zweite Elektrode 86 ist ausschließlich im mittleren Bereich mit dem rückstellfähig flexiblen, biegbaren Federstahl-Folienelement 84 verbunden, was an dem Befestigungspunkt 90 in Fig. 3 gezeigt ist.

An dem zweiten Elektroden-Trägerkörper 82 liegt als Andrückkörper 92 das Vorsprungelement 64 an dessen einer den Aufnahmeraum 66 begrenzenden Innenseite an. Hierzu weist der Andrückkörper 92 zwei Andrückvorsprünge 94 auf, die im Wesentlichen symmetrisch zum Befestigungspunkt 90 der zweiten Elektrode 86 an dem zweiten Elektroden-Trägerkörper 82 angeordnet sind. Beide Andrückvorsprünge 94 liegen in demjenigen Bereich des zweiten Trägerkörpers 82 an, in dem das Federstahl-Folienelement 84 des zweiten Trägerkörpers 82 die Vertiefung 80 des ersten Trägerkörpers 74 überspannt. Zu erwähnen ist ferner noch, dass sich das Federstahl-Folienelement 84 an den gegenüberliegenden Begrenzungsrandabschnitten 95 der Vertiefung 80 des ersten Trägerkörpers 74 an diesem abstützt; diese Begrenzungsrandabschnitte 95 der Vertiefung 80 bilden also die Auflagen für die Abstützabschnitte 96 des zweiten Elektroden-Trägerkörpers 82.

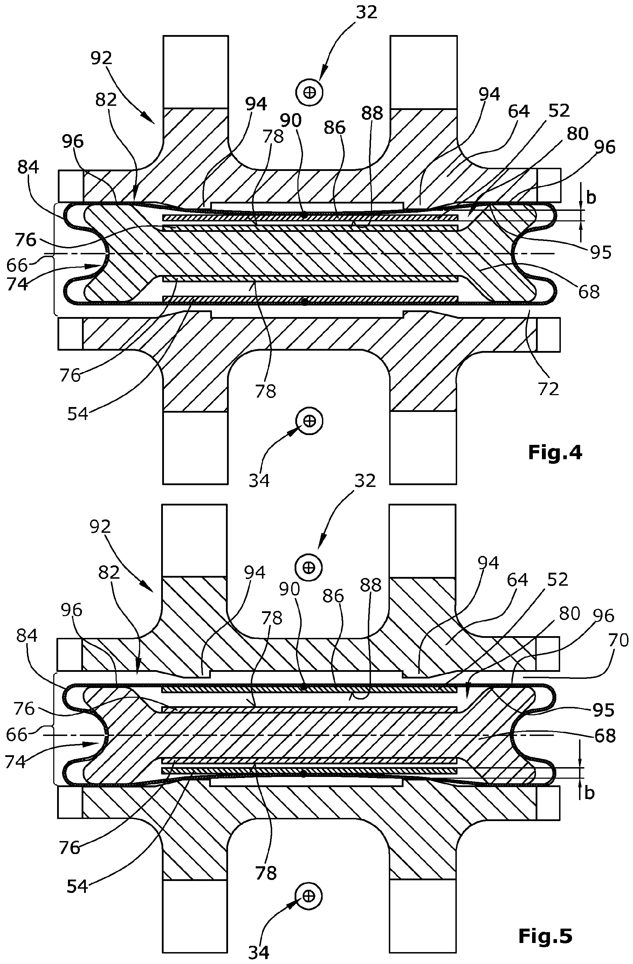

Durch die zuvor beschriebene Konstruktion, die im Übrigen auch an der, bezogen auf Fig. 3, Unterseite des ersten Trägerkörpers 74 im Zusammenspiel mit dem ebenfalls auf Fig. 3 bezogenen unteren Teil des Andrückkörpers 92 ausgebildet ist (und dort den zweiten Sensor 54 bildet), wird erreicht, dass eine innerhalb des Aufnahmeraums 66 erfolgende, relativ kleine Hubbewegung des ersten Trägerkörpers 74 bzw. des Fortsatzes 68 in eine dem gegenüber größere Verschiebung der beiden Elektroden 76,86 umgesetzt wird. Dies wird anhand eines Vergleichs der Fig. 3 mit jeder der Fign. 4 und 5 deutlich, die die Bewegung des ersten Elektroden-Trägerkörpers 74 relativ zum Andrückkörper 92 zeigen, und zwar je nachdem, ob auf die Unterseite 46 (Fig. 4) oder auf die Oberseite 42 (Fig. 5) der Betätigungsleiste 22 eine Betätigungskraft ausgeübt wird. Die Verschiebung b der zweiten Elektrode 86 (siehe Fign. 4 und 5 und in Fig. 3 angedeutet) ist größer als der Abstand a gemäß (Fig. 3), um den sich der Tastenkörper 26 bei Betätigung bewegt.

Durch die in den Fign. 3 bis 5 gezeigte mechanische Konstruktion wird also eine Art Übersetzungsgetriebe zur Umsetzung des Hubs zwischen dem ersten Elektroden-Trägerkörper 74 relativ zum Andrückkörper 92 in eine demgegenüber größere Annäherung der beiden Elektroden 76,86 geschaffen.

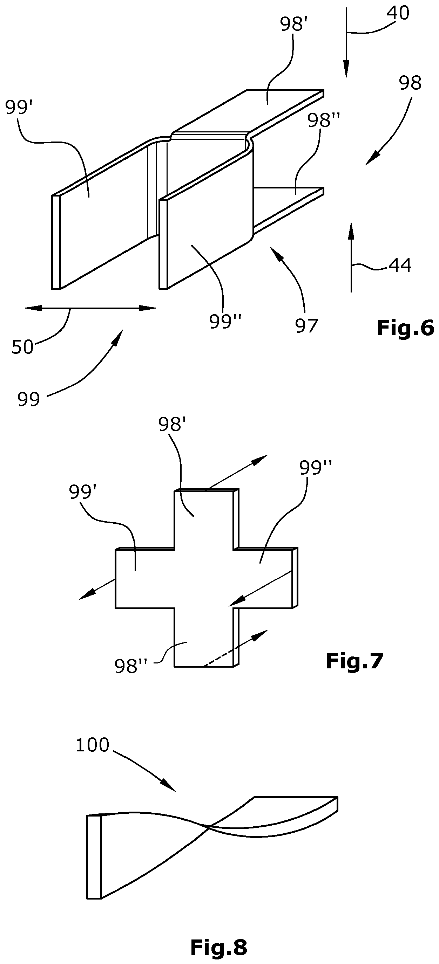

Fign. 6 und 7 zeigen eine alternative Ausgestaltung eines Aufhängungselements 97, das zwei U-förmig gebogene Abschnitte 98,99 aus Federstahlband oder gestanztem Federstahl-Flachmaterial aufweist und in der gezeigten Orientierung mit dem Abschnitt 98 an dem Trägerkörper 28 sowie mit dem Abschnitt 99 an dem Tastenkörper 26 befestigt ist. Der Abschnitt 98 ist dabei in Richtung der Pfeile 40 und 44 (siehe Fig. 1) auf- und abbewegbar, während der Abschnitt 99 in Richtung des Doppelpfeils 50 seitlich bewegbar ist. Fig. 7 zeigt, wie die beiden Abschnitte 98,99 ausgehend von einem kreuzförmigen Federstahl-Flachmaterial durch 90°-Abwinkelungen der Schenkel 98',98" (Bildung des Abschnitts 98 - in Fig. 7 angedeutet durch die von den Schenkeln 98',98" ausgehenden Pfeile) und durch 90°-Abwinkelung der Schenkel 99',99" (Bildung des Abschnitts 99 - in Fig. 7 angedeutet durch die von den Schenkeln 99',99" ausgehenden Pfeile) erstellt werden. Ein einzelnes Federstahlband, das über seine Länge oder aber auf einen (Mitten-)Längsabschnitt zentriert um 90° um die Längsachse verdreht ist, kann ebenso gut als Aufhängungselement 97 genutzt werden (siehe das Ausführungsbeispiel eines derartigen Aufhängungselements 100 in Fig. 8).

### BEZUGSZEICHENLISTE

- 10: Gehäuse der Bedienvorrichtung
- 12: Bedienvorrichtung
- 14: Vorderseite des Gehäuses
- 16: Drucktasten
- 18: Drehknopf
- 20: Anzeigeeinheit
- 22: Betätigungsleiste des Tastenkörpers
- 24: Betätigungsende des Tastenkörpers
- 26: Tastenkörper
- 28: Trägerkörper
- 30: Lager für den Tastenkörper
- 32: Aufhängungselemente des Lagers
- 34: Aufhängungselemente des Lagers
- 36: Aufhängungsebene
- 38: Aufhängungsebene
- 40: Pfeil
- 42: Oberseite der Betätigungsleiste
- 44: Pfeil
- 46: Unterseite der Betätigungsleiste
- 48: Vibrationsaktuator
- 50: Doppelpfeil
- 52: Wegsensor
- 54: Wegsensor
- 56: Auswerteeinheit
- 58: Näherungssensorik
- 60: Elektroden der Näherungssensorik
- 62: Symbolfelder auf der Betätigungsleiste
- 64: Vorsprungelement
- 66: Aufnahmeraum für das Vorsprungelement
- 68: Fortsatz
- 70: Zwischenraum
- 72: Zwischenraum
- 74: erster Elektroden-Trägerkörper
- 76: erste Elektrode
- 78: Elektrodenfläche der ersten Elektrode
- 80: Vertiefung
- 82: zweiter Elektroden-Trägerkörper
- 84: Federstahl-Folienelement
- 86: zweite Elektrode
- 88: Elektrodenfläche der zweiten Elektrode
- 90: Befestigungspunkt
- 92: Andrückkörper
- 94: Andrückvorsprünge am Andrückkörper
- 95: Begrenzungsrandabschnitt der Vertiefung
- 96: Abstützabschnitte des zweiten Elektroden-Trägerkörpers
- 97: Aufhängungselement
- 98: erster Abschnitt des Aufhängungselements
- 98': Schenkel dieses ersten Abschnitts
- 98": Schenkel dieses ersten Abschnitts
- 99: zweiter Abschnitt des Aufhängungselements
- 99': Schenkel dieses zweiten Abschnitts
- 99": Schenkel dieses zweiten Abschnitts
- 100: Aufhängungselement

## Patentansprüche

1. Bedienvorrichtung (12) für eine Fahrzeugkomponente, insbesondere für ein Radio, ein CD- und/ oder DVD-Abspielgerät, ein Navigationsgerät, ein Infotainment-Gerät, ein Heizungs- oder Klimasteuergerät oder für ein Mensch-Maschine-Interface, mit
- einem Gehäuse (10) mit einer Vorderseite (14),
- einem eine Längserstreckung aufweisenden Tastenkörper (26), der ein über die Vorderseite (14) des Gehäuses (10) vorstehendes Betätigungsende (24) und ein innerhalb des Gehäuses (10) angeordnetes Lagerende aufweist,
- wobei das Betätigungsende (24) eine Oberseite (42) sowie eine Unterseite (46) aufweist, die sich in einem Winkel von ungleich Null Winkelgrad über die Vorderseite (14) überstehend erstrecken und die zur Eingabe eines Bedienbefehls durch manuelle auf die Ober- oder Unterseite (42,46) erfolgende Kraftausübung betätigbar ist,
- einem Trägerkörper (28), der ein Lager (30) aufweist, durch das der Tastenkörper (26) in zwei zueinander im Wesentlichen orthogonalen Raumachsen bewegbar ist,
- wobei das Lager (30) mindestens drei Aufhängungselemente (32,34) aufweist, mittels derer das Lagerende des Tastenkörpers (26) an dem Trägerkörper (28) bewegbar gehalten ist und die in mindestens zwei voneinander beabstandeten Aufhängungsebenen (36,38) angeordnet sind, die sich zueinander sowie zur Längserstreckung des Tastenkörpers (26) parallel erstrecken.

2. Bedienvorrichtung nach Anspruch 1, **dadurch gekennzeichnet, dass** das Lager (30) ein vom Trägerkörper (28) abstehendes Vorsprungselement (64) aufweist, das im Wesentlichen in der gleichen Raumrichtung wie die Aufhängungselemente (32,34) von dem Trägerkörper (28) absteht und zwischen den beiden Aufhängungselementen (32,34) angeordnet ist, und dass der Tastenkörper (26) bei Betätigung an dem Vorsprungselement (64) des Lagers (30) anliegen kann.

3. Bedienvorrichtung nach Anspruch 1 oder 2, **dadurch gekennzeichnet, dass** zwei Aufhängungselemente (32,34) in einer gemeinsamen Aufhängungsebene (36,38) angeordnet sind und dass sich die anderen Aufhängungselemente (32,34) in mindestens einer anderen weiteren Aufhängungsebene (36,38) erstrecken.

4. Bedienvorrichtung nach einem der Ansprüche 1 bis 3, **dadurch gekennzeichnet, dass** drei Aufhängungselemente (32,34) vorgesehen sind.

5. Bedienvorrichtung nach einem der Ansprüche 1 bis 4, **dadurch gekennzeichnet, dass** vier Aufhängungselemente (32,34), auf zwei Aufhängungsebenen (36,38) verteilt, vorgesehen sind, wobei sich jeweils zwei Aufhängungselemente (32,34) in einer gemeinsamen Aufhängungsebene (36,38) erstrecken.

6. Bedienvorrichtung nach einem der Ansprüche 1 bis 5, **dadurch gekennzeichnet, dass** die Aufhängungselemente (32,34) sowohl druck- als auch zugkraftwiderstandsfähig und biegesteif sind und/ oder dass die Aufhängungselemente (32,34) als Federstahlstäbe ausgebildet sind.

7. Bedienvorrichtung nach einem der Ansprüche 1 bis 6, **dadurch gekennzeichnet, dass** die Aufhängungselemente (34,36) über ihre gesamte Erstreckung zwischen dem Trägerkörper (28) und dem Tastenkörper (26) in den beiden im Wesentlichen orthogonal zueinander verlaufenden Raumachsen verbiegbar oder in einem ersten Abschnitt (98) längs der einen Raumachse und in einem zweiten Abschnitt (99) längs der anderen Raumachse verbiegbar sind, wobei im letztgenannten Fall (i) die Aufhängungselemente (97) jeweils ein rückstellfähiges, flaches Streifenmaterial, insbesondere ein Federstahlband aufweisen, das um seine Längsachse um 90° gedreht relativ zueinander ausgerichtet ist und/oder (ii) jeder der Abschnitte (98,99) als U-förmig gebogenes, rückstellfähiges, flaches Streifenmaterial, insbesondere Federstahlband, ausgebildet ist und die beiden U-förmigen Streifenmaterialabschnitte (98,99) bezüglich ihrer beiden Paare von Schenkeln um 90° zueinander verdreht sowie ausgehend von ihren Basisabschnitten in entgegengesetzte Richtungen weisend ausgerichtet sind.

8. Bedienvorrichtung nach einem der Ansprüche 1 bis 7, **gekennzeichnet durch** mindestens einen Bewegungssensor (52,54) zur Erfassung einer Parallelverschiebung des Tastenkörpers (26) bei manueller Kraftausübung auf die Ober- oder Unterseite (42,46) des Betätigungsendes.

9. Bedienvorrichtung nach Anspruch 8, **dadurch gekennzeichnet, dass** der mindestens eine Bewegungssensor (52,54) als zwischen dem Trägerkörper (28) und dem Lagerende des Tastenkörpers (26) angeordneter, mit beiden in Wirkverbindung stehender Druck- oder Kraftsensor ausgebildet ist.

10. Bedienvorrichtung nach einem der Ansprüche 1 bis 9, **gekennzeichnet durch** eine Auswerteeinheit zur Umsetzung eines Bedienbefehls bei Bedienung des Betätigungsendes (24) des Tastenkörpers (26) und/oder einen Aktuator zur insbesondere oszillierenden Bewegung des Tastenkörpers (26) in zur Bewegung des Tastenkörpers (26) bei manueller Bedienung von dessen Betätigungsende orthogonal verlaufender Richtung.

## Claims

1. An operating device (12) for a vehicle component, in particular a radio, a CD and/or DVD player, a navigation device, an infotainment device, a controller for a heating or air-conditioning device, or a man-machine interface, comprising
- a housing (10) having a front face (14),
- a key body (26) having a length, which comprises an actuation end (24) protruding beyond the front face (14) of the housing (10) and a bearing end arranged inside the housing (10),
- wherein the actuation end (24) has an upper side (42) and a lower side (46), which extend beyond the front face (14) under an angle different from zero degrees and which are actuable for inputting an operating command by manual exertion of force on the upper or lower side (42, 46),
- a supporting body (28) having a bearing (30) by which the key body (26) can be moved along two spatial axes that are substantially orthogonal with respect to each other,
- wherein the bearing (30) comprises at least three suspension elements (32, 34) by means of which the bearing end of the key body (26) is movably mounted at the supporting body (28) and which are arranged in at least two mutually spaced suspension planes (36, 38) that are parallel to each other and to the longitudinal dimension of the key body (26).

2. The operating device of claim 1, **characterized in that** the bearing (30) comprises a projection element (64) protruding from the supporting body (28), which protrudes from the supporting body (28) in substantially the same spatial direction as the suspension elements (32, 34) and is arranged between the two suspension elements (32, 34), and that the key body (26) may possibly rest on the projection element (64) of the bearing (30) when operated.

3. The operating device of claim 1 or 2, **characterized in that** two suspension elements (32, 34) are respectively arranged in a common suspension plane (36, 38), and that the other suspension elements (32, 34) extend in at least one other additional suspension plane (36, 38).

4. The operating device of one of claims 1 to 3, **characterized in that** three suspension elements (32, 34) are provided.

5. The operating device of one of claims 1 to 4, **characterized in that** four suspension elements (32, 34) are provided which are distributed onto two suspension planes (36, 38), wherein two suspension elements (32, 34) respectively extend in a common suspension plane (36, 38).

6. The operating device of one of claims 1 to 5, **characterized in that** the suspension elements (32, 34) are pressure and tension resistant and rigid and/or that the suspension elements (32, 34) are designed as spring steel bars.

7. The operating device of one of claims 1 to 6, **characterized in that** the suspension elements (32, 34) are bendable along their entire length between the supporting body (28) and the key body (26) along the two spatial axes that are substantially orthogonal to each other, or they are bendable along one spatial axis in a first section (98) and along the other spatial axis in a second section (99), wherein in the latter case (i) the suspension elements (97) each comprise a resilient, planar strip material, in particular a spring steel band, which is twisted by 90° about its longitudinal axis, and/or (ii) each of the sections (98, 99) may be formed as a resilient planar strip material, in particular a spring steel band, bent into a U-shape, and the two U-shaped strip material sections (98, 99) may be turned by 90° with respect to their two pairs of legs and may be directed in opposite directions, seen from their base sections.

8. The operating device of one of claims 1 to 7, **characterized by** at least one movement sensor (52, 54) for the detection of a parallel displacement of the key body (26) when manual force is exerted on the upper or the lower side (42, 46) of the actuation end.

9. The operating device of claim 8, **characterized in that** the at least one movement sensor (52, 54) is configured as a pressure or force sensor arranged between and in operative connection with both the supporting body (28) and the bearing end of the key body (26).

10. The operating device of one of claims 1 to 9, **characterized by** an evaluation unit for converting an operation command when the actuation end (24) of the key body (26) is actuated and/or an actuator for moving the key body (26), in particular in an oscillating manner, in a direction orthogonal to the movement of the key body (26) when the actuation end thereof is actuated manually.

## Revendications

1. Dispositif de commande (12) destiné à un composant de véhicule, en particulier une radio, un lecteur de CD et/ou de DVD, un appareil de navigation, un système d'information-divertissement, un appareil de commande de chauffage ou de climatisation ou une interface homme-machine, comprenant
- un boîtier (10) pourvu d'un côté avant (14),
- un corps de clavier (26) présentant une extension longitudinale et comportant une extrémité d'actionnement (24) saillant du côté avant (14) du boîtier (10) et une extrémité formant palier disposé à l'intérieur du boîtier (10),
- l'extrémité d'actionnement (24) comportant un côté supérieur (42) et un côté inférieur (46) qui s'étendent avec un angle non nul en faisant saillie du côté avant (14) et qui peut être actionnée par application manuelle d'une force exercée sur le côté supérieur ou le côté inférieur (42,46) pour saisir une instruction de commande,
- un corps de support (28) comportant un palier (30) qui permet de déplacer le corps de clavier (26) suivant deux axes spatiaux sensiblement orthogonaux l'un à l'autre,
- le palier (30) comportant au moins trois éléments de suspension (32,34) qui permettent de maintenir de manière déplaçable l'extrémité formant palier du corps de clavier (26) sur le corps de support (28) et qui sont disposés dans au moins deux plans de suspension (36, 38) espacés l'un de l'autre qui s'étendent parallèlement l'un à l'autre et à l'extension longitudinale du corps de clavier (26).

2. Dispositif de commande selon la revendication 1, **caractérisé en ce que** le palier (30) comporte un élément saillant (64) faisant saillie du corps de support (28), qui s'étend en saillie du corps de support (28) dans sensiblement la même direction spatiale que les éléments de suspension (32, 34) et qui est disposé entre les deux éléments de suspension (32, 34), et **en ce que** le corps de clavier (26) peut venir en appui, lorsqu'il est actionné, sur l'élément saillant (64) du palier (30).

3. Dispositif de commande selon la revendication 1 ou 2, **caractérisé en ce que** deux éléments de suspension (32, 34) sont disposés dans un plan de suspension commun (36, 38) et **en ce que** les autres éléments de suspension (32, 34) s'étendent dans au moins un autre plan de suspension supplémentaire (36, 38).

4. Dispositif de commande selon l'une des revendications 1 à 3, **caractérisé en ce qu'**il est prévu trois éléments de suspension (32, 34).

5. Dispositif de commande selon l'une des revendications 1 à 4, **caractérisé en ce qu'**il est prévu quatre éléments de suspension (32, 34) répartis sur deux plans de suspension (36, 38), les deux éléments de suspension respectifs (32, 34) s'étendant dans un plan de suspension commun (36, 38).

6. Dispositif de commande selon l'une des revendications 1 à 5, **caractérisé en ce que** les éléments de suspension (32, 34) sont à la fois résistants en compression et en traction et rigides et/ou **en ce que** les éléments de suspension (32, 34) sont conçus sous la forme de barres en acier à ressort.

7. Dispositif de commande selon l'une des revendications 1 à 6, **caractérisé en ce que** les éléments de suspension (32, 34) sont pliables sur toute leur étendue entre le corps de support (28) et le corps de clavier (26) dans les deux axes spatiaux sensiblement orthogonaux l'un à l'autre ou sont pliables dans une première partie (98) le long d'un axe spatial et dans une deuxième partie (99) le long de l'autre axe spatial,
dans ce dernier cas (i) les éléments de suspension (97) comportant chacun une bande de matière plate et élastique, en particulier une bande en acier à ressort, lesquelles bandes sont orientées l'une par rapport à l'autre à 90° autour de leur axe longitudinal et/ou (ii) chacune des parties (98, 99) étant conçue comme une bande de matière plate et élastique courbée en forme de U, en particulier une bande en acier à ressort, et les deux parties (98, 99) de bande de matière en forme de U étant orientées, quant à leur deux paires de branches, à 90° l'une par rapport à l'autre et de manière à pointer dans des directions opposées depuis leurs parties de base.

8. Dispositif de commande selon l'une des revendications 1 à 7, **caractérisé par** au moins un capteur de mouvement (52, 54) destiné à détecter un déplacement parallèle du corps de clavier (26) lorsqu'une force est exercée manuellement sur le côté supérieur ou le côté inférieur (42, 46) de l'extrémité d'actionnement.

9. Dispositif de commande selon la revendication 8, **caractérisé en ce que** l'au moins un capteur de mouvement (52, 54) est conçu comme un capteur de pression ou de force disposé entre le corps de support (28) et l'extrémité formant palier du corps de clavier (26) et en liaison fonctionnelle avec les deux.

10. Dispositif de commande selon l'une des revendications 1 à 9, **caractérisé par** une unité d'évaluation destinée à la conversion d'une instruction de commande lors de la commande de l'extrémité d'actionnement (24) du corps de clavier (26) et/ou par un actionneur destiné à déplacer, notamment de manière oscillante, le corps de clavier (26) dans une direction s'étendant orthogonalement au mouvement du corps de clavier (26) lorsque son extrémité d'actionnement est commandée manuellement.
